# EUROPEAN PATENT APPLICATION

(11) **EP 4 822 739 A1**
(43) Date of publication of application: **14.10.2026**
(21) Application number: 24900476.3
(22) Date of filing: 25.11.2024
(51) Int. Cl.: H01L 21/66

(54) **INSPECTION SYSTEM, INSPECTION METHOD, AND SHELL STRUCTURE**

(30) Priority: 07.12.2023 JP 2023207126
(71) Applicant: Tokyo Electron Limited, Tokyo 107-6325 (JP)
(72) Inventor: TASHIRO, Koichiro, Nirasaki City, Yamanashi 407-8511 (JP); KOBAYASHI, Masahito, Nirasaki City, Yamanashi 407-8511 (JP)
(74) Representative: Hoffmann Eitle
(86) International application number: PCT/JP2024/041592
(87) International publication number: WO 2025/121182

(57) **Abstract**

An inspection system includes: a joining device configured to join a substrate and a jig in a state in which a conductive part of the substrate and a contact part of the jig are brought into a contacted and conductive state, to form a shell structure from which an electrode of the jig is exposed; a conveying module connected to the joining device and configured to convey the shell structure formed by the joining device; a determination unit configured to determine whether a joining state of the shell structure formed by the joining device is normal or abnormal; and an inspection device connected to the conveying module and configured to inspect the substrate via the electrode of the jig of the shell structure determined to be normal by the determination unit.

## Description

### TECHNICAL FIELD

The present disclosure relates to an inspection system, an inspection method, and a shell structure.

### BACKGROUND ART

PTL 1 discloses a manufacturing method for forming a shell structure by joining a contact jig (contact substrate) in order to reduce a needle pressure to be applied to a substrate from a probe of an inspection device. The inspection device of the inspection system brings a probe into contact with an electrode of the contact jig of the formed shell structure, transmits an electrical signal to a plurality of semiconductor devices on the substrate, and inspects the electrical characteristics of each semiconductor device.

### CITATION LIST

### PATENT LITERATURE

PTL 1: Japanese Patent Application Laid-Open Publication No. 2023-95494

### SUMMARY OF THE INVENTION

### TECHNICAL PROBLEM

The present disclosure provides a technique for forming a shell structure using a substrate and a jig and inspecting the substrate of the shell structure efficiently and accurately.

### SOLUTION TO THE PROBLEM

According to one aspect of the present disclosure, an inspection system is provided, including: a joining device configured to join a substrate and a jig in a state in which a conductive part of the substrate and a contact part of the jig are brought into a contacted and conductive state, to form a shell structure from which an electrode of the jig is exposed; a conveying module connected to the joining device and configured to convey the shell structure formed by the joining device; a determination unit configured to determine whether a joining state of the shell structure formed by the joining device is normal or abnormal; and an inspection device connected to the conveying module and configured to inspect the substrate via the electrode of the jig of the shell structure determined to be normal by the determination unit.

### ADVANTAGEOUS EFFECTS OF THE INVENTION

According to one aspect, by forming a shell structure using a substrate and a jig, it is possible to inspect the substrate of the shell structure efficiently and accurately.

### BRIEF DESCRIPTION OF THE DRAWINGS

[FIG. 1A] FIG. 1A is a side cross-sectional view before a shell structure is formed.
[FIG. 1B] FIG. 1B is a side cross-sectional view after the shell structure is formed.
[FIG. 2] FIG. 2 is a plan view of a contact jig applied to the shell structure.
[FIG. 3] FIG. 3 is a plan view schematically showing the overall configuration of an inspection system according to a first embodiment.
[FIG. 4] FIG. 4 is a side cross-sectional view schematically showing a joining device of an inspection system.
[FIG. 5] FIG. 5 is a side cross-sectional view schematically showing a shell structure determination device.
[FIG. 6] FIG. 6 is a flowchart showing an inspection method according to an embodiment.
[FIG. 7] FIG. 7 is a plan view schematically showing an overall configuration of an inspection system according to a second embodiment.
[FIG. 8A] FIG. 8A is an enlarged cross-sectional view showing a contact part of a contact jig according to a first modified example.
[FIG. 8B] FIG. 8B is an enlarged cross-sectional view showing a contact part of a contact jig according to a second modified example.

### DETAILED DESCRIPTION OF THE INVENTION

Hereinafter, embodiments of the present disclosure will be described with reference to the drawings. In the drawings, the same components are denoted by the same reference numerals and redundant descriptions may be omitted.

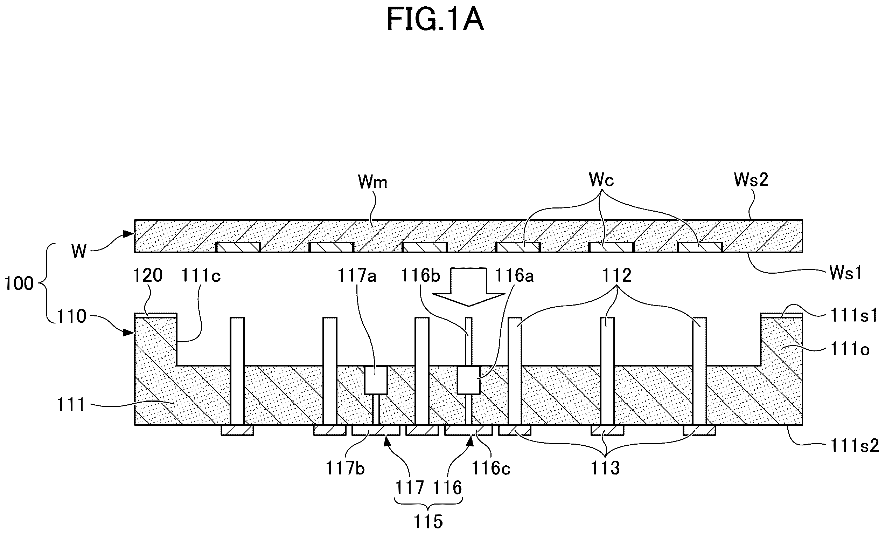

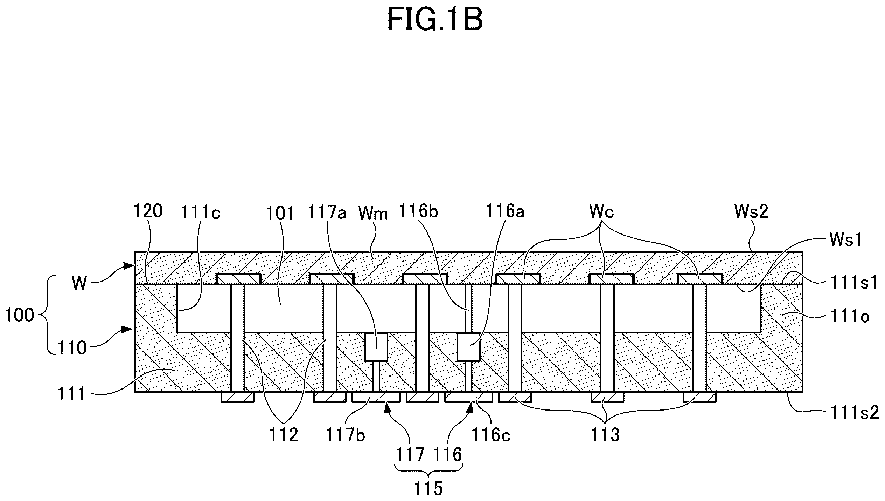

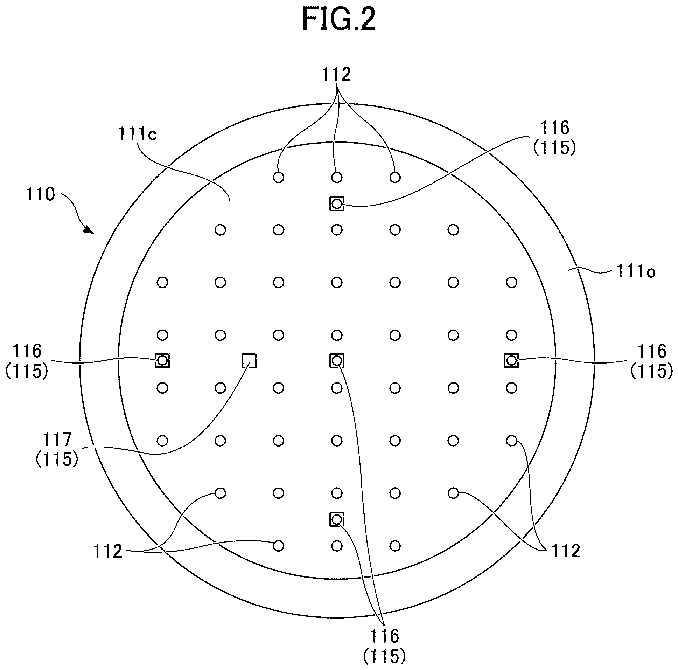

First, in order to facilitate understanding of an inspection system 1 according to the present disclosure, a shell structure 100 formed during an inspection will be described with reference to FIGS. 1 and 2. FIG. 1 are views showing the shell structure 100 according to an embodiment. FIG. 1A is a side cross-sectional view before the shell structure 100 is formed, and FIG. 1B is a side cross-sectional view after the shell structure 100 is formed. FIG. 2 is a plan view of a contact jig 110 applied to the shell structure 100.

The shell structure 100 is a structure formed for inspection of a substrate W and disassembled after inspection of the substrate W. The shell structure 100 is formed by joining an inspection-target substrate W to be inspected and the contact jig 110.

Examples of the inspection-target substrate W include a wafer on which a plurality of semiconductor devices, which are Devices Under Test (DUT), are arranged in a matrix. For example, the substrate W is composed of silicon, a compound semiconductor (SiC, GaAs, SiC, GaN, InP, or the like), or the like. The substrate W is not limited to a wafer, and may be a carrier including semiconductor devices, a glass substrate, a single chip, an electronic circuit substrate, and the like.

The substrate W includes a plate-shaped substrate body Wm and a plurality of conductive parts Wc. The substrate body Wm is formed in a perfect circle shape when viewed in a plan view, and includes a plurality of semiconductor devices inside. The diameter of the substrate body Wm is set to, for example, 30 cm. The substrate body Wm has one surface Ws1 that faces the contact jig 110 and the other surface Ws2 that is the opposite surface. Although, in FIG. 1A, the one surface Ws1 and the other surface Ws2 are shown to be flat, the one surface Ws1 and the other surface Ws2 may have irregularities in accordance with respective semiconductor devices.

The plurality of conductive parts Wc are formed in the one surface Ws1 of the substrate body Wm and are electrically conductive to suitable semiconductor devices of the substrate body Wm. Examples of the conductive parts Wc include electrode pads, metal bumps, and the like of the semiconductor devices. Although FIG. 1A illustrates a form of the conductive parts Wc being embedded in the substrate W, the conductive parts Wc may project from the one surface Ws1 of the substrate W.

Each conductive part Wc is composed of a conductive metal material, such as aluminum (Al), copper (Cu), and the like. The conductive parts Wc are provided in parallel with each other at intervals of, for example, 10 µm or less.

The contact jig 110 is joined with the substrate W in a peelable manner. The contact jig 110 includes a jig body 111, a plurality of contact parts 112, and a plurality of electrode pads 113.

The jig body 111 is formed in a perfect circle shape (see also FIG. 2) having substantially the same diameter as that of the substrate body Wm, and constitutes a part to be joined with the substrate body Wm. The jig body 111 is formed thicker than the substrate body Wm. The jig body 111 has a recess 111c inside an annular outer periphery 111o. The recess 111c is formed on the side of one surface 111s1 of the jig body 111. The jig body 111 may have a shape different from that of the substrate W, and may be formed in a perfect circle shape having a diameter greater than that of the substrate W, or in a polygonal shape, such as a square shape and the like.

For example, a material having a thermal expansion coefficient equal or similar to the thermal expansion coefficient of the substrate body Wm is applied to the jig body 111 in order to inhibit deviation between the substrate W and the contact jig 110 when the temperature of the shell structure 100 changes. As an example, a contact substrate composed of the same material as that of the substrate body Wm may be applied to the jig body 111. Alternatively, the jig body 111 may be composed of a glass substrate having a thermal expansion coefficient equal or similar to that of the substrate W, or a substrate formed by laminating a semiconductor substrate and a glass substrate.

The plurality of contact parts 112 are pin-shaped members extending linearly along the thickness direction of the jig body 111. The projection ends of the contact parts 112 contact the corresponding conductive parts Wc, by joining the substrate W and the contact jig 110. Therefore, the contact parts 112 are arranged at positions capable of facing the corresponding conductive parts Wc of the substrate W.

Each of the contact parts 112 penetrates the thickness part of the jig body 111 and projects into the recess 111c. The extending length of each contact part 112 is substantially equal to the thickness of the jig body 111 or slightly longer than the thickness of the jig body 111. Therefore, the projection end of each contact part 112 coincides with the opening of the recess 111c (the one surface 111s1 of the jig body 111) or slightly projects from the opening. Further, each contact part 112 is elastically deformable upon contact with the corresponding conductive part Wc. Thus, each contact part 112 contacts the corresponding conductive part Wc of the substrate W with an appropriate needle pressure (contact pressure).

The plurality of electrode pads 113 are formed on the other surface 111s2 of the jig body 111. The plurality of electrode pads 113 are set to be at an interval greater than the interval between the conductive parts Wc of the substrate W and/or to have an area larger than the area of the conductive parts Wc. For example, the interval between the electrode pads 113 can be set to 50 µm to 500 µm. Each electrode pad 113 is composed of a metal material, such as Al, Cu, and the like. The metal material of the electrode pads 113 may be plated with gold (Au) or the like.

Each electrode pad 113 is electrically connected to the corresponding contact part 112. Although FIG. 1 shows a configuration in which each contact part 112 extends linearly such that each contact part 112 and the corresponding electrode pad 113 are connected with each other on the other surface 111s2, each contact part 112 may be bent or curved in the jig body 111. Thus, even when the interval between the conductive parts Wc and the interval between the electrode pads 113 are different, each conductive part Wc and the corresponding electrode pad 113 can be electrically conductive via the corresponding contact part 112.

Further, in the contact jig 110, adjacent contact parts 112 are insulated from each other and adjacent electrode pads 113 are insulated from each other.

A joining part 120 is formed on the outer periphery 111o of the one surface 111s1 of the contact jig 110. The outer periphery 111o forms a part projecting from the bottom surface of the recess 111c and forming an annular loop, and the joining part 120 covers the entirety of the projection end surface of the outer periphery 111o. The joining part 120 may be composed of an adhesive agent, or may be a modified layer obtained by modifying the surface of the jig body 111, as will be described later specifically.

The one side surface 111s1 of the contact jig 110 is joined with the one surface Ws1 of the substrate W via the joining part 120, thereby forming an internal space 101 in which the recess 111c is sealed. Contact parts, at which the respective conductive parts Wc and the corresponding contact parts 112 contact, are located in the internal space 101. By joining the substrate W and the contact jig 110 in a reduced pressure atmosphere, it is possible to maintain the internal space 101 in the reduced pressure atmosphere. The shell structure 100 can inhibit oxidation of each conductive part Wc due to exposure to the open air. Alternatively, the substrate W and the contact jig 110 can be joined as the shell structure 100 in an inert gas atmosphere. Thus, the shell structure 100 can maintain the internal space 101 in the inert gas atmosphere.

Further, the contact jig 110 according to the present disclosure includes a detector 115 for detecting an index for determining the joining state between the substrate W and the contact jig 110. Examples of the index for determining the joining state include a pressure (needle pressure) applied to the substrate W from the contact part 112 of the contact jig 110, an internal pressure (degree of vacuum) in the sealed internal space 101, and the like. Thus, the contact jig 110 includes a plurality of needle pressure sensors 116 and a space pressure sensor 117 to constitute the detector 115.

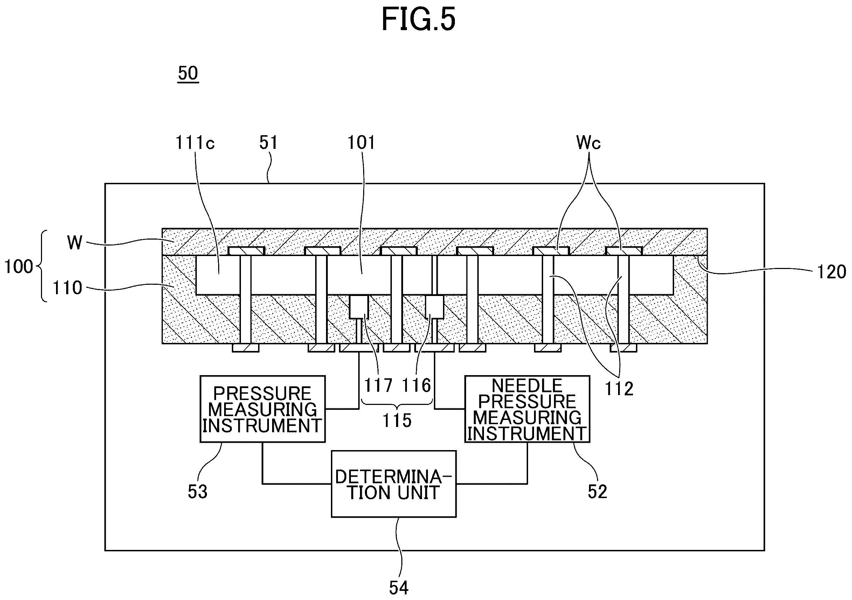

Each needle pressure sensor 116 includes a sensor body 116a in the jig body 111 and a pin 116b projecting from the sensor body 116a into the recess 111c (see FIG. 1A). Further, the needle pressure sensor 116 includes a connector 116c conductive to the sensor body 116a on the other surface 111s2 of the jig body 111. Each needle pressure sensor 116 configured in this way can detect the pressure (needle pressure) from the pin 116b onto the substrate W under the control from a later-described needle pressure measuring instrument 52 (see FIG. 5) connected to the connector 116c.

The space pressure sensor 117 includes a detector element 117a exposed to the recess 111c in the jig body 111 and a connector 117b conductive to the detector element 117a on the other surface 111s2 of the jig body 111. Each space pressure sensor 117 configured in this way can detect the pressure (internal pressure) in the internal space 101 between the substrate W and the contact jig 110 under the control from a later-described pressure measuring instrument 53 (see FIG. 5) connected to the connector 117b.

As shown in FIG. 2, the plurality of needle pressure sensors 116 are provided in the center of the recess 111c and near the outer periphery 111o at major four orientations of the recess 111c, respectively, and a total of five needle pressures 116 are provided. By each needle pressure sensor 116 detecting the needle pressure at the corresponding position, the inspection system 1 can recognize any uneven loading by each needle pressure sensor 116. On the other hand, one space pressure sensor 117 is provided at an intermediate position between two needle pressure sensors 116. The number of the needle pressure sensors 116 is not particularly limited, and for example, only one may be provided. The positioning of each needle pressure sensor 116 and the space pressure sensor 117 is also not particularly limited, and may be desirably designed.

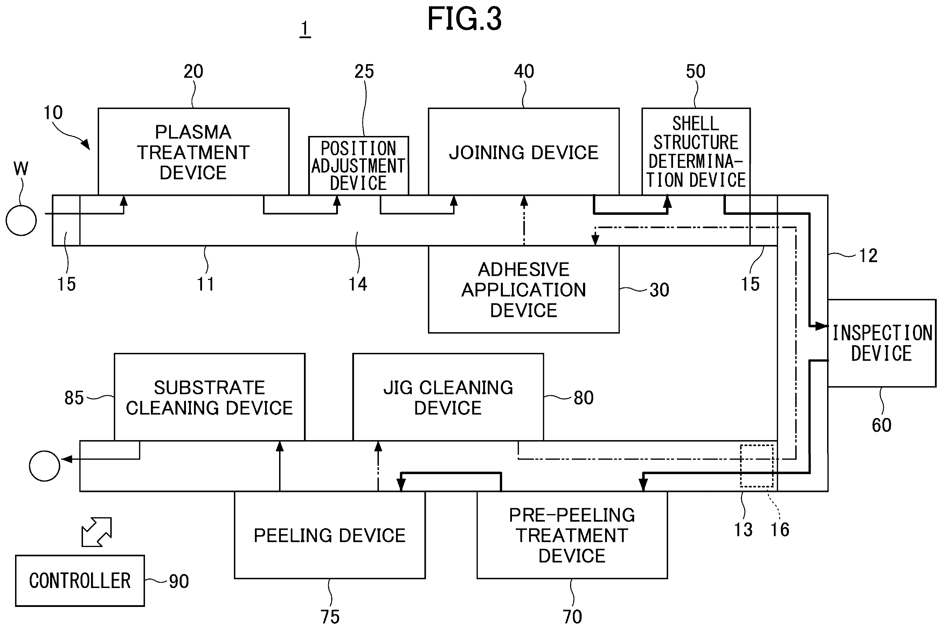

The shell structure 100 formed during an inspection is basically configured as described above, and the inspection system 1 configured to perform inspection by forming this shell structure 100 will be described below with reference to FIG. 3. FIG. 3 is a plan view schematically showing the overall configuration of the inspection system 1 according to the first embodiment.

### [First Embodiment]

The inspection system 1 according to the first embodiment stocks a plurality of contact jigs 110 inside, forms a shell structure 100 and performs inspection while conveying a substrate W to reach a location in the inspection system 1, and disassembles the shell structure 100 after the inspection. The inspection system 1 includes a conveying module 10, a reduction treatment device (plasma treatment device) 20, a position adjustment device 25, an adhesive application device 30, a joining device 40, a shell structure determination device 50, an inspection device 60, a pre-peeling treatment device 70, a peeling device 75, a jig cleaning device 80, and a substrate cleaning device 85. The inspection system 1 also includes a controller 90 for controlling the operation of each device.

The conveying module 10 conveys a substrate W to three regions: a formation region 11 for forming the shell structure 100, an inspection region 12 for inspecting the substrate W, and a disassembly region 13 for disassembling the shell structure 100. The formation region 11, the inspection region 12, and the disassembly region 13 each extend linearly. The conveying module 10 has a substantially letter-C shape as a whole because the formation region 11 and the inspection region 12 are connected to be orthogonal to each other, and the inspection region 12 and the disassembly region 13 are connected to be orthogonal to each other. The formation region 11, the inspection region 12, and the disassembly region 13 are not limited to being continuous with each other, and a subset or all of them may be provided at distant positions.

Each region of the conveying module 10 includes a floor frame 14 that extends linearly, and a conveying device (not shown) that moves along the longitudinal direction of the floor frame 14. The floor frame 14 may be formed as a flat road surface or may have a guide rail, depending on the conveying mechanism of the conveying device. The conveying device moves over the floor frame 14 while supporting the substrate W by an arm (not shown) to convey the substrate W to a position facing each device. Further, the conveying device moves the arm forward and backward at the position facing each device to load or unload the substrate W into or from each device.

In the formation region 11, in order to form the shell structure 100, the reduction treatment device 20, the position adjustment device 25, the adhesive application device 30, the joining device 40, and the shell structure determination device 50 are connected in this order from the upstream side to the downstream side in the conveying direction of the substrate W. In the formation region 11, for example, the devices are installed on both sides of the floor frame 14.

Further, the conveying module 10 can decompress the formation region 11 to a vacuum atmosphere, while leaving the inspection region 12 and the disassembly region 13 in the open-air atmosphere. When forming the shell structure 100 in the formation region 11, this facilitates bringing the internal space 101 of the shell structure 100 into a vacuum atmosphere. In the inspection system 1, the formation region 11 does not need to be set to a vacuum atmosphere, and may be set to an inert gas atmosphere with supply of an inert gas, such as nitrogen (N₂) gas or the like, in order to inhibit oxidation of the conductive parts Wc. Further, in the inspection system 1, the region to be set to a vacuum atmosphere is not limited to the formation region 11, and, for example, a vacuum atmosphere may be formed over the formation region 11, the inspection region 12, and the disassembly region 13.

The formation region 11 of the conveying module 10 forms a space sealed from the outside, and includes load lock modules 15 at the inlet and outlet of the formation region 11, respectively. For example, in the conveying module 10, a sealed space is formed over the entire length of the formation region 11 by side panels and a ceiling panel covering the floor frame 14. Upon housing the substrate W conveyed from the outside, the load lock module 15 on the inlet side is decompressed from the open-air atmosphere to a vacuum atmosphere, and then the substrate W is taken out by the conveying device in the formation region 11. Upon having the substrate W (shell structure 100) housed by the conveying device in the formation region 11, the load lock module 15 on the outlet side is pressurized from a vacuum atmosphere to the open-air atmosphere, and then the substrate W is taken out by a conveying device in the inspection region 12.

Meanwhile, only the inspection device 60 is connected to the inspection region 12. The conveying device in the inspection region 12 loads in the shell structure 100 formed in the formation region 11, conveys it to the inspection device 60, and conveys the shell structure 100 after being inspected by the inspection device 60 to the disassembly region 13.

In the disassembly region 13, in order to disassemble the shell structure 100, the pre-peeling treatment device 70, the peeling device 75, the jig cleaning device 80, and the substrate cleaning device 85 are connected in this order from the upstream side to the downstream side in the conveying direction of the substrate W. On the upstream side of the disassembly region 13 (or, on the downstream side or the upstream side of the inspection region 12), a buffer 16 for temporarily placing the shell structure 100 of the inspection region 12 is provided. Also in the disassembly region 13, for example, the devices are provided on both sides of the floor frame 14.

The reduction treatment device 20 provided in the formation region 11 performs plasma treatment on the substrate W before forming the shell structure 100 to remove an oxide film formed on the surfaces of the conductive parts Wc of the substrate W. Therefore, the substrate W with the one surface Ws1 facing upward (facing the upper side in the vertical direction) is loaded into the reduction treatment device 20. For example, the reduction treatment device 20, to which a publicly-known device can be applied, supplies an etching gas to form plasma, thereby etching the surfaces of the conductive parts Wc composed of aluminum. The type of the etching gas can be selected appropriately depending on the material of the conductive parts Wc, and, for example, a hydrogen-containing gas, a chlorine-containing gas, and the like can be applied. As the etching gas, it is preferable to apply hydrogen gas, which does not require detoxification and does not corrode the devices. The substrate W from which the oxide film has been removed is formed into the shell structure 100 while being inhibited from being oxidized again because it is moved through the vacuum atmosphere in the formation region 11.

The position adjustment device 25 is loaded with the substrate W, from which the oxide film has been removed, by the conveying module 10, detects misalignment and the circumferential-direction orientation (attitude) of the substrate W, and adjusts the misalignment and attitude of the substrate W in cooperation with the conveying device in the formation region 11. Further, the position adjustment device 25 flips the substrate W, the one surface Ws1 of which is facing upward, such that the one surface Ws1 faces downward in order that the substrate W and the contact jig 110 can be joined by the joining device 40. The conveying device in the formation region 11 unloads the substrate W with the one surface Ws1 facing downward, and conveys it to the joining device 40.

The adhesive application device 30, to which the contact jig 110 is conveyed by the conveying device in the formation region 11, forms the joining part 120 (see FIG. 1A) by applying an adhesive to the surface of the outer periphery 111o of the contact jig 110. In the embodiment, a UV-curable resin is applied as the adhesive. The adhesive application device 30 includes, for example, a nozzle (not shown) for applying the adhesive, and forms the joining part 120 over the entirety, in the circumferential direction, of the projection end surface of the outer periphery 111o. The conveying device in the formation region 11 unloads the contact jig 110 on which the joining part 120 is formed and conveys it to the joining device 40.

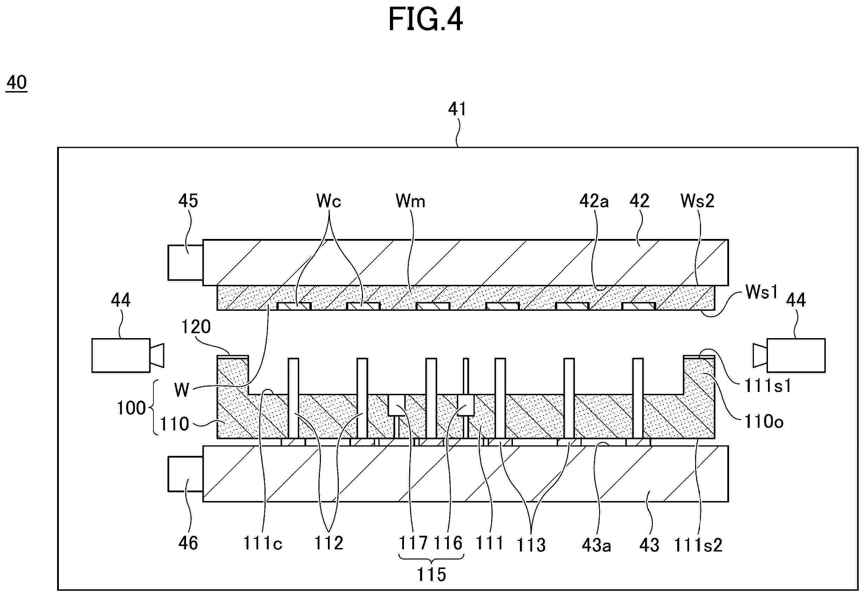

FIG. 4 is a side cross-sectional view schematically showing the joining device 40 of the inspection system 1. As shown in FIG. 4, the joining device 40 joins the substrate W and the contact jig 110 inside a processing vessel 41. The joining device 40 includes an upper chuck 42 for holding the substrate W, a lower chuck 43 for holding the contact jig 110, and UV irradiators 44 inside the processing vessel 41.

The upper chuck 42 holds the other surface Ws2 of the substrate W from above with the one surface Ws1 of the substrate W facing downward. The upper chuck 42 is displaced vertically by an elevating mechanism (not shown) at a set position. The lower surface of the upper chuck 42 is a clamp surface 42a capable of clamping the substrate W. A plurality of suction tubes are connected to the clamp surface 42a, and a clamp pressure for vacuum-clamping the substrate W is applied through the suction tubes. The upper chuck 42 may be an electrostatic chuck for electrostatically clamping the substrate W.

Further, the upper chuck 42 includes a plurality of holding pins (not shown) that are raised and lowered in the vertical direction by a driver (not shown) to vacuum-clamp the substrate W. Each holding pin projects from the clamp surface 42a of the upper chuck 42 and clamps the substrate W positioned by the conveying device at a substrate passing/receiving position. Then, the upper chuck 42 raises each holding pin to vacuum-clamp the substrate W on the clamp surface 42a horizontally.

The lower chuck 43 holds the other surface 111s2 of the contact jig 110 from below with the one surface 111s1 of the contact jig 110 facing upward. The lower chuck 43 is supported by a moving mechanism (not shown) that moves in a horizontal direction and the vertical direction relative to the upper chuck 42. The moving mechanism of the lower chuck 43 conveys the contact jig 110 between a jig passing/receiving position and a joining position facing the upper chuck 42.

The lower chuck 43 includes a plurality of lift pins (not shown) that rise and lower in the vertical direction. Each lift pin rises to the contact jig 110 loaded to the jig passing/receiving position by the conveying device, and receives the contact jig 110. The lower chuck 43 lowers each lift pin to vacuum-clamp the contact jig 110 on a clamp surface 43a horizontally. An electrostatic chuck for electrostatically clamping the contact jig 110 may also be applied to the lower chuck 43.

The joining device 40 captures an image of the lower chuck 43 and the contact jig 110 by an upper camera 45 provided on the upper chuck 42, and captures an image of the upper chuck 42 and the substrate W by a lower camera 46 provided on the lower chuck 43. The joining device 40 aligns the reference point of the substrate W with the reference point of the contact jig 110 by using the captured image information from the upper camera 45 and the captured image information from the lower camera 46, and adjusts the horizontal positions of the substrate W and the contact jig 110. The joining device 40 may capture images of the substrate W and the contact jig 110 by inserting a bridge mechanism including the upper camera 45 and the lower camera 46 between the upper chuck 42 and the lower chuck 43.

Further, the joining device 40 raises the lower chuck 43 by the moving mechanism of the lower chuck 43, and brings the joining part 120 on the outer periphery of the contact jig 110 into contact with the outer periphery of the substrate W. Thus, the substrate W and the contact jig 110 are integrated in the Z-axis direction. The joining device 40 may lower the upper chuck 42, or move both the upper chuck 42 and the lower chuck 43.

The UV irradiators 44 perform UV irradiation when joining the substrate W and the contact jig 110 (for example, after the outer periphery of the substrate W comes into contact with the contact jig 110). A plurality of UV irradiators 44 are provided on the sides of the upper chuck 42 and the lower chuck 43 along the circumferential direction, and emit UV from their entirety along the circumferential direction. Alternatively, one or a plurality of UV irradiators 44 may be configured to emit UV while moving along the circumferential direction. The joining part 120 between the substrate W and the contact jig 110 is cured by receiving UV from the UV irradiators 44, thereby joining the substrate W and the contact jig 110.

By operating as described above, the joining device 40 forms the shell structure 100 in which the substrate W and the contact jig 110 are joined in the vacuum atmosphere (or an inert gas atmosphere). The shell structure 100 exposes the electrode pads 113 of the contact jig 110 while concealing the conductive parts Wc unexposed, thereby allowing the semiconductor devices on the substrate W to be inspected via the electrode pads 113. The inspection system 1 causes the shell structure 100 formed by the joining device 40 to be conveyed to the shell structure determination device 50 by the conveying device in the formation region 11, and determines the joining state of the shell structure 100.

FIG. 5 is a side cross-sectional view schematically showing the shell structure determination device 50. As shown in FIG. 5, the shell structure determination device 50 includes a housing container 51 for housing the shell structure 100 (contact jig 110), a needle pressure measuring instrument 52, a pressure measuring instrument 53, and a determination unit 54.

The needle pressure measuring instrument 52 is connected to the connector 116c of each needle pressure sensor 116 of the shell structure 100 loaded into the housing container 51. The needle pressure measuring instrument 52 measures the needle pressure of each needle pressure sensor 116 of the shell structure 100 by operating each needle pressure sensor 116 via the connector 116c, and transmits the measurement information to the determination unit 54.

The pressure measuring instrument 53 is connected to the connector 117b of the space pressure sensor 117 of the shell structure 100 loaded into the housing container 51. The pressure measuring instrument 53 measures the space pressure by the space pressure sensor 117 of the shell structure 100 by operating each needle pressure sensor 116 via the connector 116c, and transmits the measurement information to the determination unit 54.

The determination unit 54 determines the joining state of the shell structure 100 based on the measurement information from the needle pressure measuring instrument 52 and the measurement information from the pressure measuring instrument 53. The determination unit 54 may be provided in the controller 90 instead of being provided in the shell structure determination device 50.

For example, the determination unit 54 stores in advance a needle pressure tolerable range for comparing the needle pressure of the shell structure 100 and a space pressure tolerable range for comparing the space pressure of the shell structure 100. The determination unit 54 compares the measurement information of each needle pressure with the needle pressure tolerable range, determines that the joining state is abnormal when each needle pressure is outside the needle pressure tolerable range, and determines that the joining state is normal when each needle pressure is within the needle pressure tolerable range. Alternatively, the determination unit 54 may be configured to calculate a difference (uneven load) between the minimum value and the maximum value among the respective needle pressures, determine that the joining state is abnormal when the difference exceeds a threshold value, and determine that the joining state is normal when the difference is equal to or less than the threshold value. The determination unit 54 compares the measurement information of the space pressure with the space pressure tolerable range, determines that the joining state is abnormal when the space pressure is outside the space pressure tolerable range, and determines that the joining state is normal when the space pressure is within the space pressure tolerable range.

When determining that the joining state of the shell structure 100 is abnormal, the inspection system 1 omits inspection by the inspection device 60, disassembles the shell structure 100, and forms a shell structure 100 again. Thus, the inspection system 1 can stably inspect the substrate W by forestalling abnormality in the electrical characteristics of the substrate W that might be caused by abnormality in the joining state.

Referring back to FIG. 3, in the inspection region 12 of the inspection system 1, the shell structure 100 formed in the formation region 11 is conveyed, and the substrate W of the shell structure 100 is inspected by the inspection device 60 installed in the inspection region 12.

As the inspection device 60, a device that includes, for example, a tester (not shown) and a probe card (not shown) held by the tester is applied. The probe card includes a plurality of probes (not shown) that can contact the electrode pads 113 exposed from the shell structure 100. The tester transmits an electrical signal to the conductive parts Wc of the substrate W through the probes of the probe card, and the electrode pads 113 and the contact parts 112 of the shell structure 100, and receives a response signal from the substrate W, thereby inspecting the electrical characteristics of the semiconductor devices on the substrate W. After inspection by the inspection device 60, the shell structure 100 is conveyed to the disassembly region 13 by the conveying device in the inspection region 12.

The pre-peeling treatment device 70 in the disassembly region 13, into which the shell structure 100 is conveyed by the conveying device of the disassembly region 13, applies pretreatment to the shell structure 100. For example, a hot plate device for heating the shell structure 100 to a target temperature is applied as the pre-peeling treatment device 70. The target temperature is a temperature at which the adhesive force of the adhesive (UV-curable resin) on the joining part 120 can be reduced. Thus, the joining part 120 joining the substrate W and the contact jig 110 of the shell structure 100 can be easily peeled.

The peeling device 75 in the disassembly region 13, into which the shell structure 100 from the pre-peeling treatment device 70 is conveyed by the conveying device in the disassembly region 13, peels the substrate W and the contact jig 110 from each other. As the peeling device 75, for example, a device for entering a blade into the joining part 120 from a side of the shell structure 100 and pulling up the substrate W from the contact jig 110 is applied. Thus, the substrate W and the contact jig 110 are smoothly peeled.

The jig cleaning device 80 in the disassembly region 13, into which the contact jig 110 peeled apart by the peeling device 75 is conveyed, performs treatment for removing the adhesive (joining part 120) adhering to the contact jig 110. After the removal of the adhesive on the contact jig 110, the inspection system 1 conveys the contact jig 110 to the adhesive application device 30, such that the contact jig 110 can be used repeatedly for inspecting substrates W. The inspection system 1 may include a housing module for housing a plurality of contact jigs 110, such that a contact jig 110 from the jig cleaning device 80 may be in the housing module, and a contact jig 110 from the housing module may be conveyed to the adhesive application device 30.

The substrate cleaning device 85 in the disassembly region 13, into which the substrate W peeled by the peeling device 75 is conveyed, performs treatment for removing the adhesive (joining part 120) adhering to the substrate W. After the removal of the adhesive on the substrate W, the inspection system 1 conveys the substrate W to the downstream end of the disassembly region 13, thereby unloading the substrate W from the conveying module 10 and housing the substrate W in a carrier, such as FOUP and the like.

A computer including a processor, a memory, an input/output interface, a communication interface, and the like (not shown) is applied as the controller 90 of the inspection system 1. The processor is one or more selected from a Central Processing Unit (CPU), a Graphics Processing Unit (GPU), an Application Specific Integrated Circuit (ASIC), a Field-Programmable Gate Array (FPGA), a circuit composed of a plurality of discrete semiconductors, and the like, and executes and processes a program stored in the memory. The memory includes a main storage device composed of a semiconductor memory or the like, and an auxiliary storage device composed of a disk, a drive, a semiconductor memory (flash memory), or the like.

The controller 90 of the inspection system 1 controls the operations of the conveying module 10 and the respective devices, to perform control for sequentially conveying a plurality of substrates W to form one shell structure 100 after another, and sequentially inspecting the substrates W of the shell structures 100 by the inspection device 60. The controller 90 also performs control for sequentially peeling the shell structures 100 after being inspected into the substrates W and the contact jigs 110, and unloading the substrates W.

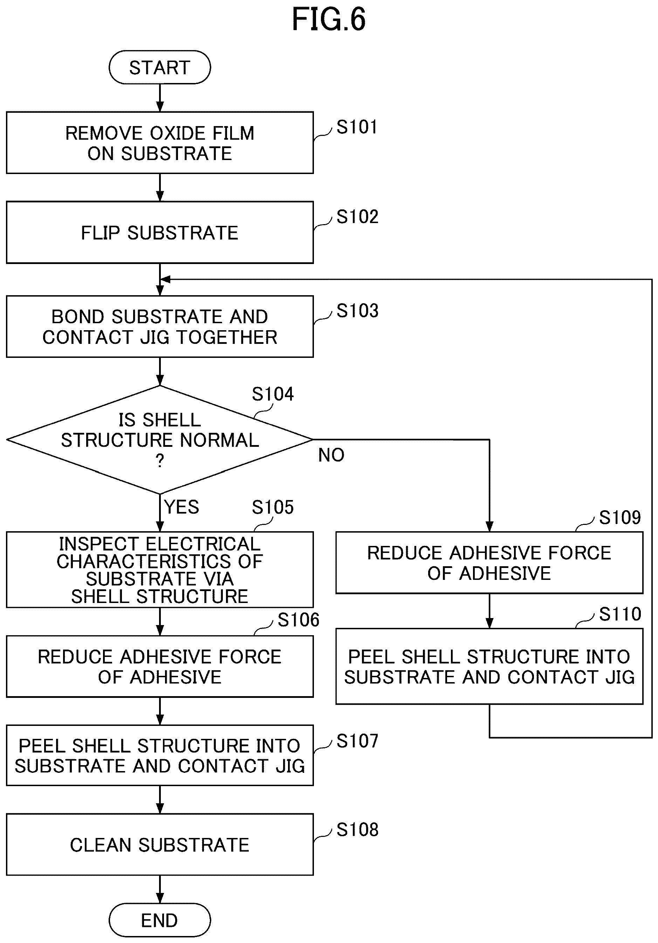

The inspection system 1 according to the embodiment is basically configured as described above, and its operation (inspection method) will be described below with reference to FIG. 6. FIG. 6 is a flowchart showing the inspection method according to the embodiment.

In the inspection method of the substrate W, the inspection system 1 performs the process flow of steps S101 to S110 shown in FIG. 6 under the control from the controller 90.

The inspection system 1 first conveys the substrate W to the reduction treatment device 20 by the conveying module 10, and removes the oxide film on the conductive parts Wc of the substrate W in the reduction treatment device 20 (step S101).

The inspection system 1 then conveys the substrate W from the reduction treatment device 20 to the position adjustment device 25 by the conveying module 10, and aligns the substrate W and flips the substrate W in the position adjustment device 25 (step S102). Thus, the substrate W is in a state in which the one surface Ws1 faces the lower side in the vertical direction.

Then, the inspection system 1 conveys the substrate W from the position adjustment device 25 to the joining device 40 by the conveying module 10, and forms the shell structure 100 by joining the substrate W and the contact jig 110 in the joining device 40 (step S103: step (A)). An adhesive is applied to the contact jig 110 by the adhesive application device 30 between steps S101 and S102 in parallel (or before step S101), and the contact jig 110 is conveyed to the joining device 40. Thus, the joining device 40 can obtain the shell structure 100 in which the substrate W and the contact jig 110 are firmly joined via the joining part 120.

After the shell structure 100 is manufactured, the inspection system 1 conveys the shell structure 100 from the joining device 40 to the shell structure determination device 50, and determines whether the joining state of the shell structure 100 is normal or not (step S104: step (B)). The determination unit 54 determines whether the shell structure 100 is normal or abnormal based on the detection information from the detector 115 of the shell structure 100 as described above. The inspection system 1 proceeds to step S105 when the joining state of the shell structure 100 is normal (step S104: YES), and proceeds to step S109 when the joining state of the shell structure 100 is abnormal (step S104: NO).

In step S105, the inspection system 1 conveys the shell structure 100 from the shell structure determination device 50 to the inspection device 60 by the conveying module 10, and inspects the electrical characteristics of the substrate W via the shell structure 100 in the inspection device 60 (step (C)). During this inspection, the inspection device 60 applies high needle pressures from respective probes to the electrode pads 113 of the shell structure 100, while applying weak needle pressures to the conductive parts Wc of the substrate W by the contact parts 112. Therefore, the inspection device 60 can favorably inspect the substrate W by inhibiting damage to the conductive parts Wc.

After the inspection of the substrate W, the inspection system 1 conveys the shell structure 100 from the inspection device 60 to the pre-peeling treatment device 70 by the conveying module 10, and heats the shell structure 100 in the pre-peeling treatment device 70 to reduce the adhesive force of the adhesive (step S106).

Next, the inspection system 1 conveys the shell structure 100 from the pre-peeling treatment device 70 to the peeling device 75 by the conveying module 10, and peels the shell structure 100 into the substrate W and the contact jig 110 in the peeling device 75 (step S107). The contact jig 110 peeled by the peeling device 75 is conveyed to the jig cleaning device 80 by the conveying module 10 to remove the adhesive, and then conveyed again to the adhesive application device 30 by the conveying module 10.

Meanwhile, the inspection system 1 conveys the substrate W peeled by the peeling device 75 to the substrate cleaning device 85 by the conveying module 10, and removes the adhesive by cleaning the substrate W in the substrate cleaning device 85 (step S108). Thus, the substrate W returns to the state before being loaded into the inspection system 1, and is recovered as the substrate W after being inspected.

Further, when it is determined in step S104 of the inspection method that the joining state of the shell structure 100 is abnormal, the inspection system 1 shifts to a process of disassembling the shell structure 100 without performing inspection. Therefore, the inspection system 1 conveys the shell structure 100 from the shell structure determination device 50 to the pre-peeling treatment device 70 by the conveying module 10, and heats the shell structure 100 in the pre-peeling treatment device 70 to reduce the adhesive force of the adhesive (step S109).

Further, the inspection system 1 conveys the shell structure 100 from the pre-peeling treatment device 70 to the peeling device 75 by the conveying module 10, and peels the shell structure 100 into the substrate W and the contact jig 110 in the peeling device 75 (step S110: step (D)). The adhesive is removed from the contact jig 110 peeled by the peeling device 75 by the jig cleaning device 80, and the contact jig 110 is then conveyed to the adhesive application device 30 for the adhesive to be applied. Further, the adhesive is removed from the substrate W peeled by the peeling device 75 by the substrate cleaning device 85, and the substrate W is then conveyed to the joining device 40. Thus, the inspection system 1 joins the substrate W and the contact jig 110 again in the joining device 40 (step S104), and then the above-described process flow can be repeated.

As described above, by forming the shell structure 100 in which the substrate W and the contact jig 110 are joined, the inspection method can stably inspect the substrate W while inhibiting damage to the substrate W. In particular, by determining the joining state of the shell structure 100, the inspection method can avoid performing inspection when an abnormality occurs in the joining state of the shell structure 100, thereby improving the throughput of the entire inspection.

The inspection system 1 and the inspection method of the present disclosure are not limited to the above-described embodiment, and various modified examples can be employed. For example, the inspection device 60 of the inspection system 1 is not limited to a device for inspecting the shell structure 100 (substrate W) one by one, but may be a device including multiple stages of (a plurality of) inspection units for housing and inspecting a plurality of shell structures 100.

The function of determining the joining state of the shell structure 100 is not limited to the shell structure determination device 50. For example, the contact jig 110 may employ a detector 115 having a wireless communication function, and transmit detection information from the detector to the controller 90 by wireless communication. The controller 90 can determine whether the joining state of the shell structure 100 is normal or abnormal based on the received detection information.

### [Second Embodiment]

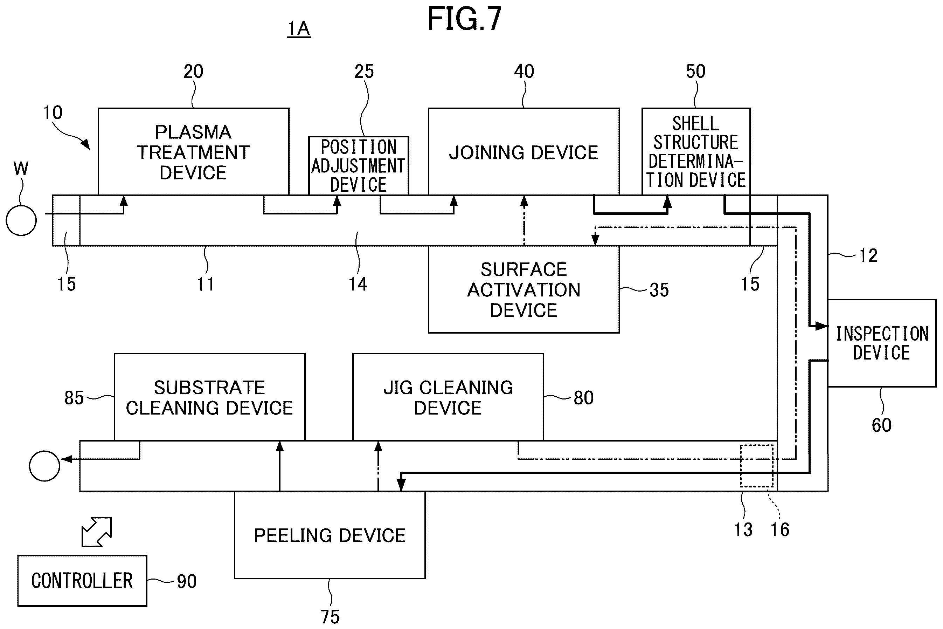

FIG. 7 is a plan view schematically showing the overall configuration of an inspection system 1A according to a second embodiment. The inspection system 1A according to the second embodiment differs from the inspection system 1 according to the first embodiment in, instead of applying an adhesive as the joining part 120 of the shell structure 100, activating the surface of the outer periphery 111o of the contact jig 110, to be joined with the substrate W at normal temperature. Thus, the inspection system 1A includes a surface activation device 35 instead of the adhesive application device 30 and does not include the pre-peeling treatment device 70 (see FIG. 3). The conveying module 10, the reduction treatment device 20, the position adjustment device 25, the joining device 40, the shell structure determination device 50, the inspection device 60, the peeling device 75, the jig cleaning device 80, and the substrate cleaning device 85 of the inspection system 1A are the same as those of the inspection system 1. Therefore, a detailed description of these devices is omitted.

The surface activation device 35 of the inspection system 1A performs, for example, a modifying treatment to cut SiO₂ bonds on the surface of the contact jig 110 to form Si dangling bonds, and further performs a hydrophilization treatment on the one surface 111s1 of the contact jig 110. In the modifying treatment, for example, oxygen gas is formed into plasma in a reduced pressure atmosphere to supply oxygen ions, thereby modifying the one surface 111s1. In the hydrophilization treatment, for example, pure water is supplied to the modified one surface 111s1 to bond OH groups to the Si dangling bonds. Thus, the surface of the outer periphery 111o of the contact jig 110 is activated. The surface modification is not limited to being performed only on the contact jig 110, and may be performed on the one surface Ws1 of the substrate W as well.

The joining device 40 can form a shell structure 100 including a joining part 120 at which the substrate W and the contact jig 110 are firmly joined, by joining them by causing the one surface Ws1 of the substrate W and the one surface Ws1 of the contact jig 110, which is surface-modified, to face each other. Therefore, the inspection device 60 can favorably inspect the electrical characteristics of the substrate W of the shell structure 100 as in the first embodiment.

The shell structure 100 is conveyed to the peeling device 75 in the disassembly region 13, and is peeled into the substrate W and the contact jig 110 by the peeling device 75. The peeling device 75 can easily peel them by entering a blade (not shown) between the substrate W and the contact jig 110, which have been joined at room temperature by hydrophilization.

As described above, also the inspection system 1A according to the second embodiment can inspect the substrate W of the shell structure 100 by easily forming the shell structure 100 of the substrate W and the contact jig 110. In particular, the inspection system 1A can facilitate planarization of the joining surface by omitting application of an adhesive, thereby enabling the substrate W and the contact jig 110 to be accurately joined.

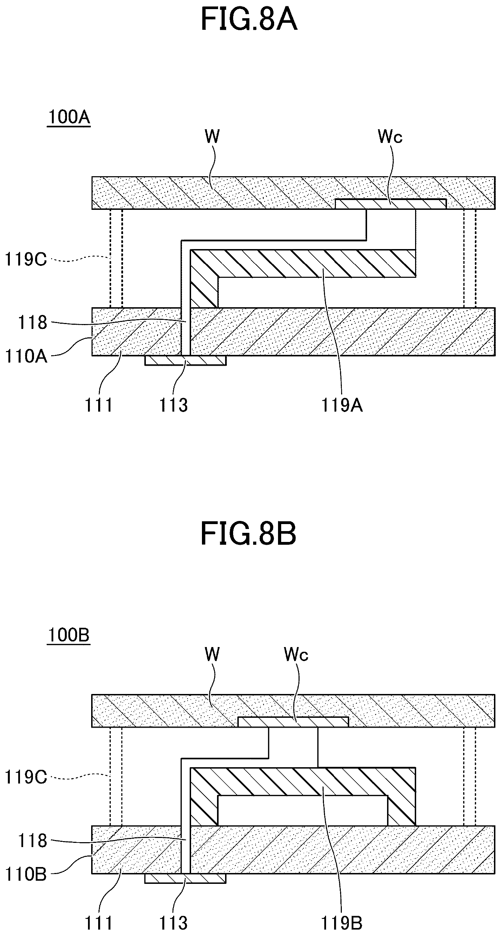

Further, the contact parts 112 of the contact jig 110, which are constituents of the shell structure 100, are not limited to a pin shape projecting linearly in the recess 111c as shown in FIG. 1, and the contact parts 112 may be configured by a structure of a cantilever beam or a clamped-clamped beam. This configuration will be described below with reference to FIGS. 8A and 8B.

FIG. 8A is an enlarged cross-sectional view showing a contact part 112A of a contact jig 110A according to a first modified example. The contact part 112A of the contact jig 110A according to the first modified example includes a crank-like letter-L shaped pin 118 contacting the conductive part Wc of the substrate W, and a support 119A supporting the letter-L shaped pin 118. The support 119A is formed in a letter-L shape projecting short from the bottom of the contact jig 110 and bending at an intermediate position, and forms a cantilever beam supporting the letter-L shaped pin 118 by the side surface and the upper surface.

The support 119A elastically supports the contact of the letter-L shaped pin 118 with the conductive part Wc. The support 119A deforms appropriately when a differential pressure is applied to the space, in which the recess 111c is sealed, from the other surface Ws2 of the substrate W and the other surface 111s2 of the contact jig 110, such that the contact state between the letter-L shaped pin 118 and the conductive part Wc can be maintained. The contact jig 110A may include another support 119C having a columnar shape (see the dotted line in FIG. 8A) and configured to receive the load of the differential pressure when the differential pressure is large.

FIG. 8B is an enlarged cross-sectional view showing a contact part 112B of a contact jig 110B according to a second modified example. The contact part 112B of the contact jig 110B according to the second modified example includes a crank-like letter-L shaped pin 118 contacting the conductive part Wc of the substrate W, and a support 119B supporting the letter-L shaped pin 118. The support 119B is formed in a letter-C shape having both ends connected to the bottom of the contact jig 110 with the part in between spaced apart from the bottom, and forms a clamped-clamped beam supporting the letter-L shaped pin 118 by the side surface and the upper surface.

This support 119B also appropriately deforms when a differential pressure is applied to the space, in which the recess 111c is sealed, from the other surface Ws2 of the substrate W and the other surface 111s2 of the contact jig 110, such that the contact state between the letter-L shaped pin 118 and the conductive part Wc cbe maintained. The contact jig 110B may also include another support 119C having a columnar shape (see the dotted line in FIG. 8B) and configured to receive the load of the differential pressure when the differential pressure is large.

The technical concept and effects of the present disclosure described in the above embodiments will be described below.

The inspection systems 1 and 1A according to a first aspect of the present disclosure include a joining device 40 configured to join a substrate W and the jig (the contact jig 110) in a state in which the conductive part Wc of the substrate W and the contact part 112 of the jig are brought into a contacted and conductive state, to form a shell structure 100 from which the electrode (the electrode pad 113) of the jig is exposed; the conveying module 10 connected to the joining device 40 and configured to convey the shell structure 100 formed by the joining device 40; the determination unit 54 configured to determine whether a joining state of the shell structure 100 formed by the joining device 40 is normal or abnormal; and the inspection device 60 connected to the conveying module 10 and configured to inspect the substrate W via the electrode of the jig of the shell structure 100 determined to be normal by the determination unit 54.

According to the above, the inspection systems 1 and 1A can inspect the substrate W while protecting the substrate W, by inspecting the substrate W by the inspection device 60 after forming the shell structure 100 by the joining device 40. In particular, the inspection systems 1 and 1A determine the joining state of the shell structure 100 formed by the joining device 40 by the determination unit 54, and inspect a normal shell structure 100 by the inspection device 60. Therefore, the inspection systems 1 and 1A can forestall occurrence of an inspection abnormality due to inspecting the substrate W of an abnormal shell structure 100, thereby improving the yield of inspection. In addition, it is possible to omit inspecting an abnormal shell structure 100, thereby improving the throughput of the entire inspection.

The conveying module 10 includes: the formation region 11 including the joining device 40; the inspection region 12 including the inspection device 60; and the disassembly region 13 for peeling the substrate W and the jig (contact jig 110) of the shell structure 100, and conveys the jig peeled in the disassembly region 13 to the formation region 11 to reuse the jig. Thus, the inspection systems 1 and 1A can repeat inspection of a plurality of substrates W by restricting the number of jigs used for the inspection, can reduce the cost required for the inspection.

Further, the conveying module 10 forms a sealed space at least in the formation region 11, and sets the sealed space in a vacuum atmosphere, or supplies an inert gas to the sealed space. Thus, the inspection systems 1 and 1A can seal the conductive part Wc of the substrate W by joining the substrate W with the jig (the contact jig 110) while inhibiting oxidization of the conductive part Wc.

Further, when the shell structure 100 is determined by the determination unit 54 to be abnormal, the substrate W and the jig (the contact jig 110) are peeled in the disassembly region 13 without performing inspection by the inspection device 60, and the peeled substrate W and jig are conveyed to the formation region 11 to form the shell structure 100 again in the formation region 11. Thus, the inspection systems 1 and 1A can perform inspection by forming a shell structure 100 again, for any shell structure 100 having abnormality in the joining state.

Further, the disassembly region 13 includes the jig cleaning device 80 for cleaning the jig (the contact jig 110) after being peeled. Thus, even in a case of reusing the jig, the inspection systems 1 and 1A can favorably join the substrate W and the jig.

The shell structure 100 includes the internal space 101 that is sealed and in which a part at which the conductive part Wc and the contact part 112 contact each other is housed, and the detector 115 for detecting an index of the joining state for performing determination by the determination unit 54 is installed in the internal space 101. Thus, the inspection systems 1 and 1A can easily obtain an index of the joining state of the shell structure 100 by the detector 115.

The detector 115 also includes the needle pressure sensor 116 for detecting a needle pressure applied to the substrate W by the contact part 112 of the jig (the contact jig 110). The inspection systems 1 and 1A can estimate the needle pressure applied to the conductive part Wc by using the detection information form the needle pressure sensor 116, and can determine whether the joining state is normal or abnormal.

The detector 115 also includes the pressure sensor (the space pressure sensor 117) for detecting the internal pressure in the internal space 101. Thus, the inspection systems 1 and 1A can estimate the degree of vacuum in the internal space 101 by using the detection information from the space pressure sensor 117, and can determine whether the joining state is normal or abnormal.

The shell structure determination device 50 connected to the detector 115 and configured to determine whether the joining state of the shell structure 100 is normal or abnormal is provided between the joining device 40 and the inspection device 60. Thus, the inspection systems 1 and 1A can determine the joining state of the shell structure 100 formed by the joining device 40 by the shell structure determination device 50 before conveying the shell structure to the inspection device 60.

Further, the jig (contact jig 110) include the supports 119A to 119 C for elastically supporting the contact parts 112A and 112B that are in contact with the conductive part Wc in the shell structure 100. Thus, even when a differential pressure is generated between the internal space 101 and the outside of the substrate W and the jig, the supports 119A to 119C elastically support the contact parts 112A and 112B to realize contact with the conductive part Wc and reduction in the needle pressure.

A second aspect of the present disclosure is the inspection method for inspecting the electrical characteristics of a substrate W, including: (A) joining the substrate W and the jig (the contact jig 110) in a state in which the conductive part Wc of the substrate W and the contact part 112 of the jig are brought into a contacted and conductive state, thereby forming the shell structure 100 from which the electrode (the electrode pad 113) of the jig is exposed; (B) after the step (A), determining whether the joining state of the shell structure 100 is normal or abnormal; and (C) inspecting the substrate W via the electrode of the jig of the shell structure 100, of which the joining state is determined to be normal in the step (B). Also in this case, the inspection method can accurately inspect the substrate W formed in the shell structure 100.

The inspection method includes (D) peeling the substrate W and the jig (the contact jig 110) of the shell structure 100, of which the joining state is determined to be abnormal in the step (B), and the substrate W peeled in the step (D) is subjected to the steps (A) and (B), and further subjected to the step (C) or the step (D). Thus, according to the inspection method, after peeling the substrate W of the shell structure 100 determined to be abnormal from the contact jig 110, the shell structure 100 can be formed again to perform inspection and the like.

A third aspect of the present disclosure is the shell structure 100 formed by joining the substrate W and the jig (the contact jig 110), wherein the substrate W includes the conductive part Wc, wherein the jig includes: the contact part 112 that is brought into a contacted and contacted state with the conductive part Wc in the recess 111c in the one surface 111s1 facing the conductive part Wc; the joining part 120 to be joined with the substrate (W) on an outer side of the recess 111c in the one surface 111s1; and the electrode (the electrode pad 113) electrically conductive with the contact part 112 on the other surface 111s2 opposite to the one surface 111s1, and wherein the detector 115 that can detect an index of the joining state between the substrate (W) and the jig is provided in the recess 111c. Also in this case, the shell structure 100 can make a normal or abnormal joining state recognizable via the detector 115, and can enhance the accuracy of inspection of the substrate W.

The inspection systems 1 and 1A, the inspection method, and the shell structure 100 according to the embodiments disclosed herein are exemplary and not restrictive in all respects. The embodiments can be modified and improved in various forms without departing from the scope and spirit of the appended claims. The particulars described in the plurality of embodiments described above can be configured in other ways to the extent that no contradiction occurs, and can be combined to the extent that no contradiction occurs.

The present application claims the priority to Japanese Patent Application No. 2023-207126, which is a basic application filed with the Japan Patent Office on December 7, 2023, the entire contents of which is hereby incorporated by reference.

### REFERENCE SIGNS LIST

1, 1A inspection system
10 conveying module
40 joining device
54 determination unit
60 inspection device
100 shell structure
110 contact jig
112 contact part
113 electrode pad
W substrate
Wc conductive part

## Claims

1. The inspection system, comprising:
a joining device configured to join a substrate and a jig in a state in which a conductive part of the substrate and a contact part of the jig are brought into a contacted and conductive state, to form a shell structure from which an electrode of the jig is exposed;
a conveying module connected to the joining device and configured to convey the shell structure formed by the joining device;
a determination unit configured to determine whether a joining state of the shell structure formed by the joining device is normal or abnormal; and
an inspection device connected to the conveying module and configured to inspect the substrate via the electrode of the jig of the shell structure determined to be normal by the determination unit.

2. The inspection system according to claim 1,
wherein the conveying module includes:
a formation region including the joining device;
an inspection region including the inspection device; and
a disassembly region for peeling apart the substrate and the jig of the shell structure, and
wherein the conveying module conveys the jig peeled in the disassembly region to the formation region to reuse the jig.

3. The inspection system according to claim 2,
wherein the conveying module forms a sealed space at least in the formation region, and sets the sealed space in a vacuum atmosphere or supplies an inert gas to the sealed space.

4. The inspection system according to claim 2,
wherein, when the shell structure is determined by the determination unit to be abnormal, the substrate and the jig are peeled apart in the disassembly region without performing inspection by the inspection device, and the substrate and the jig that are peeled apart are conveyed to the formation region to form the shell structure again in the formation region.

5. The inspection system according to claim 2,
wherein the disassembly region includes a jig cleaning device configured to clean the jig after being peeled.

6. The inspection system according to any one of claims 1 to 5,
wherein the shell structure includes an internal space that is sealed and in which a part at which the conductive part and the contact part are in contact is housed, and
wherein a detector configured to detect an index of the joining state for performing determination by the determination unit is installed in the internal space.

7. The inspection system according to claim 6,
wherein the detector includes a needle pressure sensor configured to detect a needle pressure applied to the substrate by the contact part of the jig.

8. The inspection system according to claim 6,
wherein the detector includes a pressure sensor configured to detect an internal pressure in the internal space.

9. The inspection system according to claim 6,
wherein a shell structure determination device connected to the detector and configured to determine whether the joining state of the shell structure is normal or abnormal is provided between the joining device and the inspection device.

10. The inspection system according to any one of claims 1 to 5,
wherein the jig includes a support configured to elastically support the contact part that is in contact with the conductive part in the shell structure.

11. An inspection method for inspecting electrical characteristics of a substrate, the inspection method comprising:
(A) joining the substrate and a jig in a state in which a conductive part of the substrate and a contact part of the jig are brought into a contacted and conductive state, to form a shell structure from which an electrode of the jig is exposed;
(B) after the (A), determining whether a joining state of the shell structure is normal or abnormal; and
(C) inspecting the substrate via the electrode of the jig of the shell structure, of which the joining state is determined to be normal in the (B).

12. The inspection method according to claim 11, further comprising:
(D) peeling apart the substrate and the jig of the shell structure, of which the joining state is determined to be abnormal in the (B),
wherein the substrate peeled in the (D) is subjected to the (A) and (B), and further subjected to the (C) or the (D).

13. A shell structure formed by joining a substrate and a jig,
wherein the substrate includes a conductive part,
wherein the jig includes:
a contact part that is brought into a contacted and conductive state with the conductive part, the contact part being present in a recess in one surface of the jig facing the conductive part;
a joining part to be joined with the substrate on an outer side of the recess in the one surface; and
an electrode electrically conductive with the contact part, the electrode being present on the other surface opposite to the one surface, and
wherein a detector that can detect an index of a joining state between the substrate and the jig is provided in the recess.
